(19) Europäisches Patentamt
European Patent Office
Office européen des brevets

(11) **EP 0 855 594 A2**

(12) **EUROPÄISCHE PATENTANMELDUNG**

(43) Veröffentlichungstag:
29.07.1998 Patentblatt 1998/31

(51) Int. Cl.$^6$: **G01N 27/00**

(21) Anmeldenummer: 97250382.5

(22) Anmeldetag: 22.12.1997

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(30) Priorität: 22.01.1997 DE 19701999

(71) Anmelder:
**INSTITUT FÜR HALBLEITERPHYSIK FRANKFURT (ODER) GmbH**
**15230 Frankfurt (Oder) (DE)**

(72) Erfinder: **Sorge, Roland**
**15236 Güldendorf (DE)**

(74) Vertreter: **Heitsch, Wolfgang**
**Göhlsdorfer Strasse 25g**
**14778 Jeserig (DE)**

(54) **Verfahren zur Bestimmung der Generationslebensdauer und des Dotierungsprofils mittels simultaner Hochfrequenz/Niederfrequenz-Kapazitäts-Spannungsmessungen an Metall-Isolator-Halbleiter-Strukturen**

(57)    Die Erfindung betrifft ein Meßverfahren zur Bestimmung der Generationslebensdauer, der Gleichgewichtsverarmungsweite in Inversion, der effektiven Oberflächengenerationsgeschwindigkeit und des Dotierungsprofils mit Korrektur von Minoritätsträger- und Trapumladungen während der Messung. Die Aufgabe wird dadurch gelöst, daß durch die Bereitstellung eines allgemeingültigen Meß- und Auswertealgorithmus' die Bestimmung verschiedener MOS-Parameter aus simultan gemessenen HF/NF-MOS-CV-Kennlinien ermöglicht wird, daß zur Bestimmung der Generationslebensdauer, der effektiven Oberflächengenerationsgeschwindigkeit und der Gleichgewichtsraumladungzonentiefe in Inversion die CV-Kennlinien beginnend vom Zustand der tiefen Verarmung in Richtung Akkumulation gemessen werden, wobei sich eine den Relaxationsvorgang beschleunigende abnehmende Verarmungszonenweite ergibt, daß die Gleichgewichtsraumladungzonentiefe in Inversion aus den im nichtstationären Nichtgleichgewicht gemessenen HF/NF-MOS-CV-Kennlinien im Übergangpunkt von der Generation zur Rekombination in dem gemeinsamen Schnittpunkt der aufgezeichneten HF-CV- und NF-CV-Kennlinien bei $C_{g,NF} = C_{g,HF}$ bestimmt wird und daß die Dotierungsprofilbestimmung für Verarmungstiefen größer als die Gleichgewichtsraumladungzonentiefe in Inversion auf Grundlage der simultanen Messung von HF/NF-CV-MOS-Kennlinien im nichtstationären Nichtgleichgewicht bei beliebiger Änderungsrichtung der Gatespannung mit Korrektur von Trapumladungen und des Einflusses von Minoritätsträgerinversionsladungen an der Halbleiter/Isolator-Grenzfläche erfolgt.

Fig. 1

**Beschreibung**

Die Erfindung betrifft ein Meßverfahren zur Bestimmung der Generationslebensdauer $t_g(x_g)$, der Gleichgewichtsverarmungsweite in Inversion $x_f$, der effektiven Oberflächengenerationsgeschwindigkeit $S_o$, und des Dotierungsprofils $N(x_d)$ mit Korrektur von Minoritätsträger- und Trapumladungen während der Messung.

Aus der Fachliteratur sind verschiedene MOS-CV-Meßverfahren bekannt, bei denen die zu bestimmenden Parameter $t_g(x_g)$, $x_f$, $S_o$, und $N(x_d)$ durch jeweils zugeordnete spezielle Einzelmeßverfahren ermittelt werden.

In [P. Kuper and C. R. Grimbergen, Solid-St. Electron. **21**, 549 (1978)] wird eine zeitlich getrennte Messung der HF- bzw. NF-Kapazität der MOS-Anordnung bei einer zeitllinearen Gatespannungsänderung zur Bestimmung der Generationslebensdauer $t_g$ beschrieben. Darin wurde die Gleichung

$$I_g = R \cdot C_{g,\,hf} + I_{gen} \cdot \left(1 - \frac{C_{g,\,hf}}{C_{ox}}\right)$$

für den Gatestrom, der sich aus einem Verschiebestromanteil und einen Generationsstromanteil zusammensetzt, abgeleitet. Die Generationslebensdauer wird dabei ohne Berücksichtigung eines effektiven Oberflächengenerationsanteils $S_o$ aus der Gleichung

$$I_{gen} = \frac{q \cdot n_i}{2\tau_g}(x_d - x^*)$$

mit der Verarmungsweite

$$x_d = \varepsilon_s\left(\frac{1}{C_{g,\,hf}} - \frac{1}{C_{ox}}\right)$$

bestimmt. $x^*$ ist ein als konstant angenommener Wert der Verarmungsweite, für den der Generationsstrom verschwindet. $x^*$ wird durch Extrapolation bei $I_{gen}(x_d = x^*)=0$ ermittelt. Die Messung der HF/NF-CV-Kennlinien erfolgt ausgehend vom Zustand der starken Inversion bei einer zeitlinearen Gatespannung, deren Änderungsrichtung so gewählt wurde, daß sich eine zunehmende Verarmungsweite $x_d$ ergibt. Der Gatestrom und die HF-Gatekapazität wurden nicht simultan, sondern zeitlich nacheinander bestimmt.

Der durch $S_o$ ausgedrückte Stromanteil, herrührend aus der Oberflächengeneration und der Minoritätsträgerdiffusion aus dem Bulk, wird nicht berücksichtigt.

Der Gleichgewichtswert der Verarmungsweite in Inversion, $x_f$, wird bei einer zeitlich konstanten Gatespannung nach Abwarten der Gleichgewichtsrelaxation bestimmt. Dies ist insbesondere bei sehr großen Werten für $t_g$ sehr zeitaufwendig. Aus der linearen Extrapolation der Ausgleichsgeraden im linearen Bereich der $I_{gen}(x_g)$-Kennlinie bei $I_{gen}=0$ wird in [P. Kuper and C. R. Grimbergen, Solid St. Electron. **21**, 549 (1978)] ein Tiefenwert $x^*$ zur Bestimmung der generationsaktiven Raumladungszonenweite $x_g$ aus der Verarmungstiefe $x_d$ ermittelt.

Entsprechend der verwendeten Beziehung

$$I_{gen} = \frac{q \cdot n_i}{2\tau_g}(x_d - x^*)$$

ist $x_g = x_d - x^*$, $x_g$ wird damit in Abhängigkeit vom Wert der effektiven Oberflächengenerationsgeschwindigkeit $S_o$ zu klein bestimmt. Das Dotierungsprofil $N(x_d)$ wird in [P. Kuper and C. R. Grimbergen, Solid-St. Electron. **21**, 549 (1978)] nicht bestimmt. Für die Dotierungsprofilbestimmung sind allgemein separat auszuführende HF-CV-Meßverfahren üblich, die den Inversionseinsatz infolge thermischer Generation von Minoritätsträgern in der Raumladungszone durch eine entsprechende Wahl der Meßbedingungen vermeiden. Diese werden als gepulste Messung der spannungsabhängigen HF-CV Kapazität bei Raumtemperatur [A. Goetzberger and E. H. Nicollian, Appl. Phys. Lett. **9**, 444 (1966); W. Van Gelder and E. H. Nicollian, J. Electrochem. Soc. **118**,138 (1977)] oder als nichtgepulste Messungen bei tiefen Temperaturen [J. Verjahns and R. J. van Overstraeten, Solid-State Electr. **18**, 911 (1975)] ausgeführt. In [S. T. Lin and J. Reuter, Solid-State Electr. **26**, 343 (1983)] ist eine nichtgepulste HF-CV-Messung, zur Bestimmung von $N(x_d)$ basierend auf der Korrektur des Minoritätsträgereinflusses durch Messung einer Hinlauf-HF-CV-Kennlinie (gemessen von Akkumulation in Richtung Verarmung) und einer Rücklauf-HF-CV-Kennlinie (gemessen von Verarmung in Richtung Akkumulation) beschrieben.

Der Erfindung liegt die Aufgabe zugrunde, alternativ zu der bisher bekannten sukzessiven Anwendung von verschiedenen einzelnen CV-Meßverfahren für die Extraktion von MOS-Parametern, eine zeiteffiziente Messung und Auswertung in einer Weise auszuführen, daß die Parameterextraktion mittels eines einzigen Satzes simultan gemessener HF- und NF-MOS-CV-Kennlinien, registriert bei einer zeitlich veränderlichen Gatespannung, die den Vorgang der Gleichgewichtsrelaxation vom Zustand der tiefen Verarmung in Richtung Gleichgewicht beschleunigt, ermöglicht wird. Die Aufgabe wird nach den Merkmalen des Anspruchs 1 gelöst.

Der Vorteil der Erfindung besteht darin, daß mit der Bereitstellung eines allgemeingültigen Meß- und Auswertealgorithmus' für die Bestimmung von MOS-Parametern aus einem einzigen Satz simultan gemessener HF- und NF-MOS-CV-Kennlinien, die mit kommerziell verfügbaren Meßgeräten aufgenommen werden können, eine wesentliche Zeitersparnis gegenüber der sukzessiven Anwendung von in der Literatur beschriebenen einzelnen speziellen Methoden zur Bestimmung von MOS-Parametern erreicht wird.

Ein Ausführungsbeispiel der Erfindung soll nachfolgend näher erläutert werden. In den zugehörigen Zeichnungen sind dargestellt :

Fig. 1     Meßanordnug zur simultanen Messung der HF/NF Gatekapazität unter Verwendung kommerziell verfügbarer Meßgeräte,

Fig. 2     Meßbeispiel für eine simultane HF/NF-CV-Messung mit abnehmender Verarmungsweite, d.h. es wird beginnend vom Zustand der tiefen Verarmung in Richtung Akkumulation gemessen. R=0,3V/s, T=323K, A=0,5 $10^{-3}$ cm$^2$, f=100kHz,

Fig. 3     Meßbeispiel für den bestimmten Generationsstrom $I_{gen}$ über der Tiefe $x_g$ entsprechend der in Fig. 1 gezeigten HF/NF-CV-Kennlinien. Der Schnittpunkt der Ausgleichsgeraden im linearen Teil der Kennlinie mit der Ordinate definiert den Stromwert zur Berechnung der effektiven Oberflächengenerationsgeschwindigkeit $S_o$,

Fig. 4     Meßbeispiel für das berechnete Dotierungsprofil entsprechend der in Fig. 2 gezeigten HF/NF-CV-Kennlinien.

Die Messung beginnt bei einer Startspannung im Nichtgleichgewichtszustand der tiefen Verarmung. Zu dieser Startspannung ist eine Rampenspannung mit einer zeitlichen Rampenrate R=dV$_g$/dt additiv überlagert. Im einfachsten Fall ist R konstant, was eine zeitlineare Gatespannungsänderung bedeutet. Die zeitliche Änderung der Gatespannung dV$_g$/dt ist so gewählt, daß sich während der Messung eine abnehmende Verarmungsweite einstellt. Die Meßrichtung ist also von der Verarmung in Richtung Akkumulation. Für einen p-Halbleiter ist dVg/dt < 0 und für einen n-Halbleiter dVg/dt > 0. Diese Änderungsrichtung der Rampenspannung bewirkt eine Beschleunigung des einsetzenden Relaxationsvorgangs und dadurch eine wesentliche Verkürzung der Meßzeit gegenüber einer zeitlich unveränderlichen Gatespannung. Es ist nicht wesentlich, ob zum Zeitpunkt des Gatespannungssprungs bereits eine merkliche Inversionsschicht an der Halbleiteroberfläche vorliegt oder nicht. Eine bereits zu Beginn der Messung vohandene Inversionsschicht an der Oberfläche vermindert aber den störenden Einfluß evtl. vorhandener merklicher Trapumladungen an der Grenzfläche Isolator/Halbleiter- allgemein als 'surface screening' bezeichnet-, andererseits vermindert eine Inversionsladung die maximal erreichbare Verarmungsweite. Die sich herausbildende bzw. bereits vorhandene Minoritätsladungsträgerinversionsschicht unterhalb der Isolator/Halbleitergrenzfläche kann als ein feldinduzierter pn-Übergang aufgefaßt werden, der, solange die Generation überwiegt, in Sperrichtung gepolt ist. Während der Messung verringert sich die generationsaktive Raumladungszonenweite bis diese schließlich ganz verschwindet ($x_g$=0) und der Generationsstrom $I_{gen}$ dadurch ebenfalls zu Null wird. In diesem Augenblick befindet sich das MOS-System im thermodynamischen Gleichgewicht. Deshalb ist die exakt zu diesem Zeitpunkt gemessene HF-Kapazität, die mit der Gleichgewichtsraumladungszonentiefe $x_f$ in Inversion korrespondierende Gleichgewichtskapazität $C_f$. Aus

$$I_g = R \cdot C_{g,hf} + I_{gen} \cdot \left(1 - \frac{C_{g,hf}}{C_{ox}}\right)$$

liest man für $I_{gen}$=0 die Bedingung $C_{g,NF}=C_{g,HF}$ ab. Zur Bestimmung der generationsaktiven Raumladungszonenweite $x_g$ wird der Wert der Gleichgewichtsraumladungs-zonentiefe $x_f$ in Inversion benötigt (siehe Gl (10)), der direkt mit $C_f$ korrespondiert. Die Bestimmung der Gleichgewichtsraumladungszonentiefe $x_f$ in Inversion erfolgt aus dem scharf markierten Übergang von der Generation zur Rekombination. Dieser Übergang stellt sich in Form eines gemeinsamen Schnittpunkts der aufgezeichneten HF-CV-und NF-CV-Kennlinie dar ($C_{g,nf} = C_{g,hf}$). Für diesen Gleichgewichtspunkt des Übergangs von der Generation zur Rekombination gilt $C_f = C_{g,hf}$. Deshalb ist zur Bestimmung von $x_f$ keine separate Bestimmung von $C_f$, etwa aus einer Messung von $C_{g,hf}$ nach Ende der Gleichgewichtsrelaxation in Inversion, notwendig.

Die effektive Oberflächengenerationsgeschwindigkeit $S_o$ kann aus der gemessenen $I_{gen}(x_g)$-Kennlinie extrahiert werden (siehe Gl. 14). Die gemessenen HF/NF-CV Kennlinien erlauben darüberhinaus die Bestimmung des Dotierungsprofils $N(x)$ mit Korrektur des Einflusses von Minoritätsträger- und Trapumladungen (siehe Gl.18).

Neben der oben erwähnten Messung der Generationslebensdauer und des Dotierungsprofils lassen sich andere übliche Standard-MOS-Parameter, wie, Oxiddicke, Flachbandspannung und die Grenzflächenzustandsdichte im Bandmittenbereich, ebenso aus den simultan, im nichtstationären Nichtgleichgewicht registrierten HF- bzw. NF-CV-Kennlinien, beginnend in der tiefen Verarmung in Richtung Akkumulation, bestimmen. Die Bestimmung dieser Vielzahl von wichtigen MOS-Parametern aus einer einzigen Kennliniermessung bedeutet eine wesentliche Zeitersparnis gegenüber der sukzessiven Anwendung von in der Literatur beschriebenen speziellen Methoden zur Bestimmung dieser MOS-Parameter.

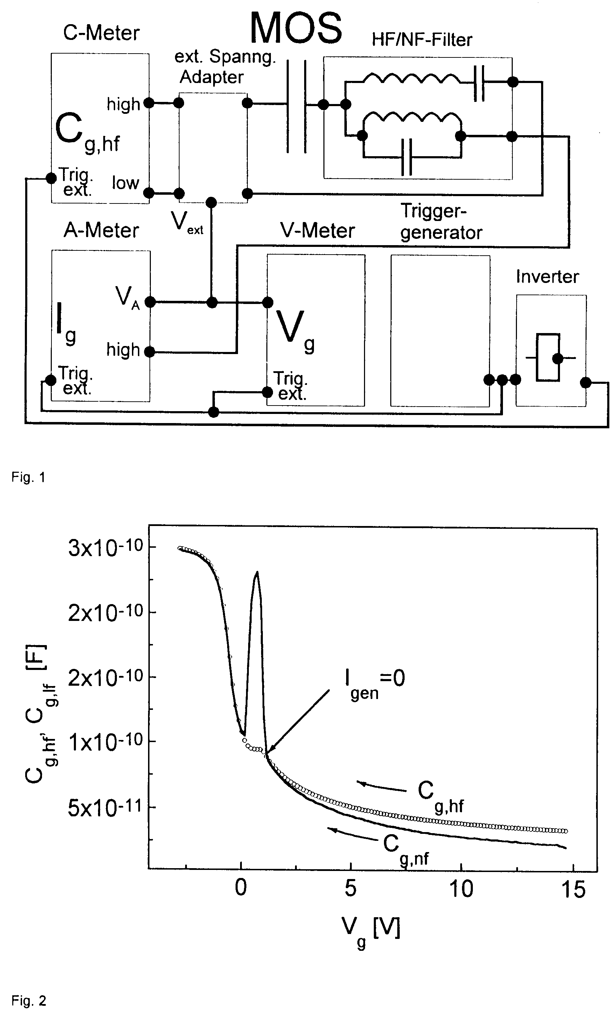

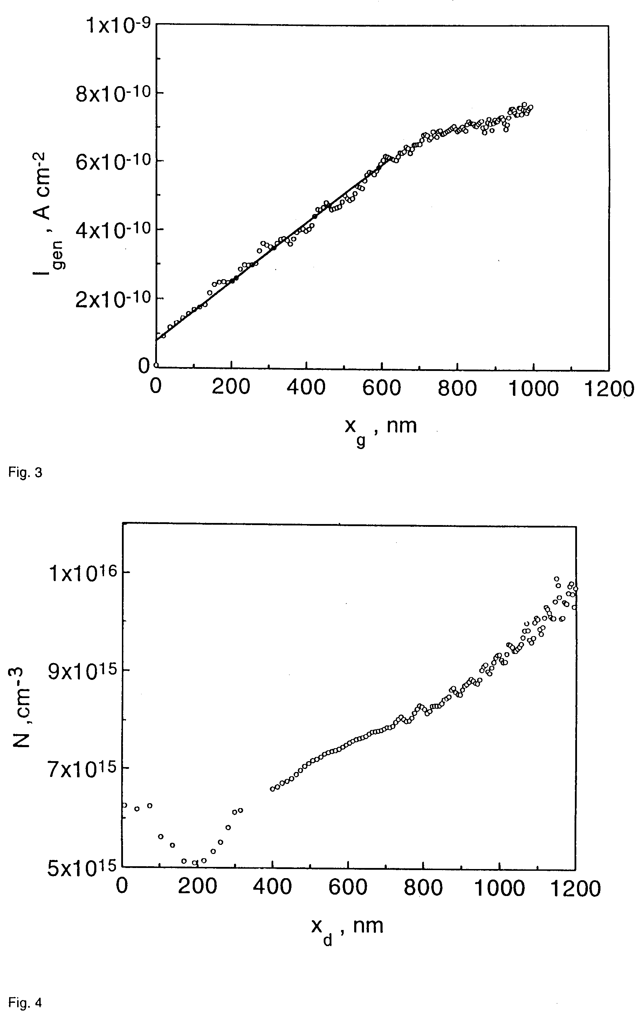

Fig.1 zeigt ein Beispiel für eine Meßanordnung zur simultanen Messung der HF/NF-Gatekapazität unter Verwendung kommerziell verfügbarer Geräte. Die Rechnersteuerung mittels eines üblichen PC ist nicht miteingezeichnet. Alle benötigten Meßgrößen $C_{g,hf}$, $I_g$, und $V_g$ werden simultan gemessen, was ein entsprechendes Triggerregime voraussetzt. Die Meßgeräte werden über einen Triggergenerator extern getriggert. Programmierbare Trigger Delay Zeiten stellen sicher, daß die Mitten der Integrationsintervalle für $C_{g,hf}$, $I_g$, und $V_g$ zeitlich exakt übereinander liegen. Kernstück der Meßanordnung zur simultanen Messung des Gatestromes und der HF-Gatekapazität ist ein HF/NF-Filter. Das Filter dient der Trennung von HF- und NF- Signal. Am Gate sind der Parallel- und der Reihenkreis des Filters zusammengeschaltet. An die Meßeingänge eines C-Meters bzw. des Strommeßgerätes gelangt so nur das jeweilige HF- bzw. NF-Signal. Als Gatevorspannung $V_g$ dient die zeitlineare Spannungsrampe. Über einen externen Gatespannungsadapter wird die Gatespannung in den Signalweg eingekoppelt. $V_A$ liegt am Chuck. Daraus ergibt sich eine zu berücksichtigende Vorzeichenumkehr für die Gatespannung bei der Datenanalyse. In Fig. 2 ist ein typisches Meßbeispiel gezeigt. Den extrahierten Generationsstrom $I_{gen}$ über $x_g$ zeigt Fig. 3 . Das bezüglich der Ladungsänderungen der Minoritätsträger und Traps an der Halbleiter/Isolatorgrenzfläche korrigierte Dotierungsprofil zeigt Fig 4. Infolge des flußgepolten feldinduzierten pn-Übergangs, der sich beim Messen beginnend in der tiefen Verarmung in Richtung Akkumulation herausbildet, versagt nach dem Einsetzen der Rekombination infolge der nicht mehr zu vernachlässigenden räumlich verteilten Inversionsladung die einfache Verarmungsnäherung als Grundvoraussetzung für die Dotierungsbestimmung. Für unser Beispiel ist dies im Tiefenbereich von 315nm - 400nm der Fall. Für diesen Tiefenbereich können bei einer Messung beginnend in der tiefen Verarmung in Richtung Akkumulation keine relevanten Dotierungswerte bestimmt werden. Bei einer Messung beginnend in Akkumulation in Richtung tiefe Verarmung besteht diese Einschränkung jedoch nicht, da die Inversionsladung als Flächenladung an der Isolator/Halbleiter-Grenzfläche lokalisiert bleibt.

Die folgenden Ableitungen verifizieren den Auswertealgorithmus zur Bestimmung der MOS-Parameter aus den gemessenen HF/NF-CV-Kennlinien.

1. Zur Bestimmung der Generationslebensdauer $t_g$ .

Der Spannungsabfall über dem MOS System setzt sich aus den folgenden Komponenten zusammen

$$V_g = \psi_s + \Phi_{MS} - \frac{1}{C_{ox}}(Q_d + Q_{it} + Q_{inv} + Q_f + O_{ot} + Q_m). \qquad (1)$$

Wir erhalten für eine Änderung der Gatespannung $dV_g$

$$dV_g = d\psi_s - \frac{1}{C_{ox}}(dQ_d + dQ_{it} + dQ_{inv}) \qquad (2)$$

Unter HF-Bedingungen mit $C_{sc,hf} = -dQ_d/dy_s$ ergibt sich

$$dV_g = -dQ_d \frac{1}{C_{g,hf}} - (dQ_{it} + dQ_{inv})\frac{1}{C_{ox}}. \qquad (3)$$

Unter NF-Bedingungen findet man analog

$$dV_g = -\frac{1}{C_{g,nf}}(dQ_d + dQ_{it} + dQ_{inv}) \ . \tag{4}$$

Mit der Ramperrate $R = dV_g/dt$ lassen sich (3) und (4) umschreiben zu

$$C_{g,hf} \cdot R = -\frac{dQ_d}{dt} - \frac{C_{g,hf}}{C_{ox}}\left(\frac{dQ_{it}}{dt} + \frac{dQ_{inv}}{dt}\right) \tag{5}$$

$$C_{g,nf} \cdot R = -\left(\frac{dQ_d}{dt} + \frac{dQ_{it}}{dt} + \frac{dQ_{inv}}{dt}\right) \ . \tag{6}$$

Der meßbare Gatestrom ist der Verschiebungsstrom durch die NF-Gatekapazität. Die NF-Gatekapazität kann sowohl über den direkt gemessenen Gatestrom $I_g = R \cdot C_{g,nf}$ als auch über Gateladungsmessungen entsprechend $C_{g,nf} = dQ_g/dV_g$ bestimmt werden. Der gemessene Generationsstrom, bestehend aus den Bulkkomponenten und einem Trapstrom infolge Umladungen von Zuständen an der Oxid/Halbleiter-Grenzfläche, ist gegeben durch

$$I_{gen} = -\left(\frac{dQ_{it}}{dt} + \frac{dQ_{inv}}{dt}\right) \ . \tag{7}$$

Je nach der sich einstellenden Oberflächen-Bandverbiegung des MOS-Systems dominiert die Trapstrom- bzw. die durch Generation und Diffusion aus dem Bulk getragene Minoritätsträgerstrom-Komponente. Mit den Gleichungen (5), (6) und (7) und der Definition für die NF-Gatekapazität

$$I_g = R \cdot C_{g,nf} \tag{8}$$

erhalten wir schließlich die gesuchte Gleichung für den Gatestrom.

$$I_g = R \cdot C_{g,hf} + I_{gen}\frac{C_{ox} - C_{g,hf}}{C_{ox}} \tag{9}$$

Die Weite des generationsaktiven Teils der Verarmungszone wird nach Bestimmung von $x_f$ nach [K. S. Rabbani, Solid-St. Electron. **30**, 607 (1987)] berechnet

$$x_g = \sqrt{x_d{}^2 - x_f{}^2/2} - x_f/\sqrt{2} \ . \tag{10}$$

Die meßbare Verarmungsweite ist

$$x_d = \varepsilon_s\left(\frac{1}{C_{g,hf}} - \frac{1}{C_{ox}}\right) \ . \tag{11}$$

Generation überwiegt in jenen Tiefenbereichen für die $p \cdot n < n_i^2$ gilt. Für diesen Fall erhält man [W. Shockley and W. T. Read, Phys. Rev. **87** 835 (1952)] die Generationsrate $g = n_i/2t_g$. Die Integration der Generationsrate über die Tiefe ergibt den tiefenabhängigen Generationsstrom $I_{gen}$

$$I_{gen}(x_g) = q\int_0^{x_g} g\, dx \ . \tag{12}$$

Unter Berücksichtigung einer effektiven Generationsgeschwindigkeit $S_o$ an der Halbleiter/Isolator-Grenzfläche erhält man die Beziehung für die Extraktion der Generationslebensdauer aus der $I_{gen}(x_g)$-Kennlinie

$$I_{gen}(x_g) = n_i \cdot q \cdot \left(\frac{x_g}{2\tau_g} + S_o\right). \tag{13}$$

Im Gegensatz zu

$$I_{gen} = \frac{q \cdot n_i}{2\tau_g}(x_d - x^*)$$

ist in dieser Modellgleichung für die Extraktion der Generationslebensdauer aus der $I_{gen}(x_g)$-Kennlinie der durch $S_o$ ausgedrückte Stromanteil infolge Oberflächengeneration und/oder Minoritätsträgerdiffüsion aus dem Bulk enthalten. Für die Bestimmung des Generationsstromes aus Gleichung (9) erhält man

$$I_{gen} = (I_g - R \cdot C_{g,hf}) \cdot \frac{C_{ox}}{C_{ox} - C_{g,hf}} \tag{14}$$

bzw.

$$I_{gen} = RC_{ox} \cdot \frac{C_{g,nf} - C_{g,hf}}{C_{ox} - C_{g,hf}} \tag{15}$$

Man erkennt aus Gl. (14), daß es für die Messung von $I_{gen}$ zunächst einmal gleichgültig erscheint, ob mit einer jeweils festen Gatespannung ($V_g$=const., R=0, P. U. Calzolari, S. Graffi, A. M. Mazzone and C. Morandi, Alta Frequenza **41**,848 (1972)) oder mit einer Gatespannungsrampe (R<>0) bei der Meßwertaufnahme gearbeitet wird. Eine Gatespannungsänderung in Richtung Akkumulation beschleunigt jedoch den Relaxationsprozeß wesentlich, so daß sich vergleichsweise kurze Meßzeiten ergeben. Von dieser Tatsache wurde bei der hier vorgestellten HF/NF-CV Rampenmethode Gebrauch gemacht.

2. Zur Bestimmung des Dotierungsprofils $N(x_d)$

Entsprechend der Verarmungsnäherung ist der Dotierungswert an der Stelle $x_d$ gegeben durch die Änderung der Majoritätsträgerladung an der Raumladungszonenkante

$$N(x_d) = \frac{1}{q} \cdot \frac{dQ_d}{dx_d} \tag{15}$$

Aus Gln. (3) und (7) erhält man

$$\frac{dV_g}{dt} = - \frac{dQ_d}{dt} \frac{1}{C_{g,hf}} + \frac{I_{gen}}{C_{ox}} \tag{16}$$

Nach Einsetzen der Gln. (11) und (16) in Gl. (15) erhält man nach Umformung

$$N(x_d) = \frac{1}{q \cdot \varepsilon} \cdot \frac{C_{g,hf}^3}{\dfrac{dC_{g,hf}}{dt}} \cdot \left(R - \frac{I_{gen}}{C_{ox}}\right) \tag{17}$$

und unter Berücksichtigung von Gl. (14) schließlich

$$N(x_d) = \frac{1}{q \cdot \varepsilon} \cdot \frac{C_{g,hf}^3}{\dfrac{dC_{g,hf}}{dV_g}} \cdot \left(1 - \frac{C_{g,nf} - C_{g,hf}}{C_{ox} - C_{g,hf}}\right) \qquad (18)$$

Der zu dem üblichen Ausdruck für die Dotierungsprofilbestimmung [J.Hilibrand and R.D. Gold, RCA Rev. **21**, 245 (1960)] zusätzliche Term in Klammern von Gl. (18) berücksichtigt die während der Messung stattfindenden Änderungen der Inversions- bzw. Trapladung an der Grenzfläche Halbleiter/Isolator.

Symbolliste:

| | |
|---|---|
| A | Gatefläche [$cm^2$] |
| C | Kapazität [F] |
| $C_f$ | HF-Gleichgewichtsgatekapazität in Inversion [$F\,cm^{-2}$] |
| $C_{g.hf}$ | HF-Gatekapazität [$F\,cm^{-2}$] |
| $C_{g,nf}$ | NF-Gatekapazität [$F\,cm^{-2}$] |
| $C_{ox}$ | MOS Oxidkapazität [$F\,cm^{-2}$] |
| g | Generationsrate [$cm^{-3}\,s^{-1}$] |
| $I_g$ | Gatestrom [$A\,cm^{-2}$] |
| $I_{gen}$ | Generationsstrom [$A\,cm^{-2}$] |
| N | Dotierstoffkonzentration [$cm^{-3}$] |
| n | Elektronendichte [$cm^{-3}$] |
| $n_i$ | intrinsische Trägerdichte [$cm^{-3}$] |
| p | Löcherdichte [$cm^{-3}$] |
| q | Elemetarladung [$q = 1.602 \cdot 10^{-19}\,C$] |
| $Q_d$ | verarmter Raumladungsanteil [$C\,cm^{-2}$] |
| $Q_{inv}$ | Inversionsladung [$C\,cm^{-2}$] |
| $Q_{it}$ | Interface Trapladung [$C\,cm^{-2}$] |
| $Q_f$ | feste Oxidladung [$C\,cm^{-2}$] |
| $Q_m$ | mobile Ionenladung im Oxid [$C\,cm^{-2}$] |
| $Q_{ot}$ | Trapladung im Oxid [$C\,cm^{-2}$] |
| R | Gatespannungsramperrate [$V\,s^{-1}$] |
| $S_o$ | effektive Oberflächengenerationsgeschwindigkeit [$cm\,s^{-1}$] |
| t | Zeit [s] |
| V | Spannung [V] |

$V_g$        Gatespannung [V]

$x_d$        Verarmungsweite [cm]

$x_f$        Gleichgewichtsverarmungsweite in Inversion [cm]

$x_g$        generationsaktiver Teil der Verarmungsweite [cm]

$F_{MS}$        Metall-Halbleiter-Austrittsarbeit [V]

$y_s$        Oberflächenbandverbiegung [V]

$t_g$        Generationslebensdauer [s]

$t_r$        Rekombinationslebensdauer [s]

HF        Hochfrequenz

NF        Niederfrequenz

MOS        Metal-Oxide-Semiconductor

**Patentansprüche**

1. Meßverfahren zur Bestimmung der Generationslebensdauer $t_g(x_g)$, der effektiven Oberflächen-generationsgeschwindigkeit $S_o$, der Gleichgewichtsraumladungszonentiefe in Inversion $x_f$ und des Dotierungsprofils $N(x_d)$ mittels Messung von MOS-CV-Kennlinien, **dadurch gekennzeichnet,** daß durch die Bereitstellung eines allgemeingültigen Meß- und Auswertealgorithmus' die Bestimmung verschiedener MOS-Parameter aus simultan gemessenen HF/NF-MOS-CV-Kennlinien ermöglicht wird, wobei zur Bestimmung der Generationslebensdauer $t_g(x_g)$, der effektiven Oberflächengenerations-geschwindigkeit $S_o$ und der Gleichgewichtsraumladungszonentiefe in Inversion $x_f$ die CV-Kennlinien beginnend vom Zustand der tiefen Verarmung in Richtung Akkumulation gemessen werden und sich dabei eine den Relaxationsvorgang beschleunigende abnehmende Verarmungszonenweite ergibt, wobei ferner die Gleichgewichtsraumladungszonentiefe in Inversion $x_f$ aus den im nichtstationären Nichtgleichgewicht gemessenen HF/NF-MOS-CV-Kennlinien im Übergangspunkt von der Generation zur Rekombination in dem gemeinsamen Schnittpunkt der aufgezeichneten HF-CV- und NF-CV-Kennlinien bei $C_{g,NF} = C_{g,HF}$ bestimmt wird und die Dotierungsprofilbestimmung für Verarmungstiefen größer als die Gleichgewichtsraumladungs-zonentiefe in Inversion $x_f$ auf Grundlage der simultanen Messung von HF/NF-CV-MOS-Kennlinien im nichtstationären Nichtgleichgewicht bei beliebiger Änderungsrichtung der Gatespannung mit Korrektur von Trapumladungen und des Einflusses von Minoritätsträgerinversionsladungen an der Halbleiter/Isolator-Grenzfläche erfolgt.

Fig. 1

Fig. 2

Fig. 3

Fig. 4